# EUROPEAN PATENT SPECIFICATION

(11) **EP 1 504 527 B1**
(45) Date of publication and mention of the grant of the patent: **07.09.2005**
(21) Application number: 03713811.2
(22) Date of filing: 28.02.2003
(51) Int. Cl.: H03G 3/20, H04B 1/16

(54) **DIGITAL AUTOMATIC GAIN CONTROL FOR TRANSCEIVER DEVICES**
DIGITALE AUTOMATISCHE VERSTÄRKUNGSREGELUNG FÜR SENDER-EMPFÄNGERVORRICHTUNGEN
COMMANDE NUMERIQUE DE GAIN AUTOMATIQUE POUR DISPOSITIFS D'EMISSION-RECEPTION

(30) Priority: 30.04.2002 DE 10219364; 27.09.2002 US 259708
(43) Date of publication of application: 09.02.2005
(73) Proprietor: ADVANCED MICRO DEVICES INC., California 94088-3453 (US)
(72) Inventor: KLUGE, Wolfram, 01109 Dresden (DE); DATHE, Lutz, 01109 Dresden (DE); EGGERT, Dietmar, 01219 Dresden (DE)
(74) Representative: Grünecker, Kinkeldey, Stockmair & Schwanhäusser Anwaltssozietät
(86) International application number: PCT/US2003/006262
(87) International publication number: WO 2003/094345

(56) References cited:
- EP-A- 0 859 462
- US-A- 5 917 865
- STROET P M ET AL: "A zero-IF single-chip transceiver for up to 22Mb/s QPSK 802.11b wireless LAN" IEEE INTERNATIONAL SOLID-STATE CIRCUITS CONFERENCE, 5 February 2001 (2001-02-05), pages 204-447, XP010536238 cited in the application
- JAYARAMAN A ET AL: "A Fully Integrated Broadband Direct Conversion Receiver for DBS Applications" IEEE INTERNATIONAL SOLID-STATE CIRCUITS CONFERENCE, 7 February 2000 (2000-02-07), pages 140-141, XP010378831 cited in the application

## Description

### Technical Field

The present invention relates to methods and apparatus used in wireless communication systems and particularly relates to the automatic gain controlling in transceiver devices used for the wireless data transfer, for example by wireless local area networks (WLAN), mobile phones and the like.

### Background Art

Currently great efforts are being made to develop transceiver devices offering a high degree of reliability at low cost. A key issue in this respect is the degree of integration with which a corresponding transceiver device may be manufactured. While for many applications, such as direct broadcast satellite (DBS) receivers and WLAN devices, this is of great importance due to cost effectiveness, in other applications such as mobile phones, mobile radio receivers and the like, low power consumption is of primary concern.

Presently, two major architectures for transceiver devices are competing on the market, wherein due to the higher degree of integration and the potential for reduction of power consumption, the so-called direct conversion architecture seems to become the preferred topography compared to the so-called super-heterodyne architecture. Super-heterodyne receivers down-convert the received radio frequency (RF) signal to a lower intermediate frequency (IF) signal that may be filtered, amplified or otherwise processed more conveniently. Although the super-heterodyne architecture is well established and allows the fabrication of reliably operating receiver devices, the highly selective IF filters that are necessary for the proper operation of these devices, require the employment of capacitors and inductors of high quality, thereby restricting the degree of integration achievable with a super-heterodyne architecture, since high quality inductors may not easily be implemented into a semiconductor substrate. Moreover, the amplifiers operating at the relatively high IF require relatively large drive currents to provide for the required gain factor so that the power consumption of these devices may not be reduced to the levels of amplifiers operating at relatively low frequencies.

In direct conversion receivers, the RF signal is directly down-converted to a DC level, i.e. the IF is zero, so that the required filters and amplifiers, except for a low noise amplifier and input filter, may operate at baseband frequencies. Thus, the required filters may be integrated into the chip bearing the all or most of the residual circuitry, while at the same time power consumption of the involved amplifiers is significantly lower than in the super-heterodyne architecture. Despite these advantages, direct conversion devices exhibit a serious draw back in that any offset drift, for example caused by a slight miss match of the local oscillator with respect to the incoming RF signal, may not easily be separated and is thus a part of the baseband signal.

Irrespective of the architecture used in obtaining the baseband signal, for proper operation receiver devices have to take account for signal strength variations of the RF signal that may be caused by environmental influences or by frequently changing the position of the receiver, as is in the case of mobile phones or portable computer devices. Moreover, in many applications it may be necessary to detect an RF signal burst to identify the start of a data transmission, wherein commonly the receiver sensitivity is at a maximum while searching for an RF burst. As soon as the RF burst is detected, however, the receiver gain has to be adjusted to the RF signal so as to generate an appropriate level of the baseband signal to accomplish a reliable data reception.

In *"A Zero-IF Single Chip Transceiver for up to 22Mb*/*sQPSK 802.11B Wireless LAN",* by Peter M. Stroet, 2001 IEEE International Solid-State Circuits Conference, a 2.45GHz wireless LAN transceiver with a direct conversion architecture for the IEEE802.11b standard that exhibits a high level of integration. This is accomplished by using only one external front end filter, one power amplifier, a baseband chip, one crystal and a battery, whereas the remaining components are included in a single chip. In principle, the chip contains a low noise amplifier (LAN) followed by a mixer and a tuneable filter unit. Subsequently, the signal is fed to a variable gain amplifier having 40dB gain in 2dB steps followed by an AC coupled driver circuit which has two gain settings, 1dB apart. From the input of the driver circuit the signal is additionally supplied to a limiter and a received signal strength indicator circuit, a low pass filter and an ADC so as to allow a state machine to determine the signal strength. Since the QPSK signal does not have a constant envelope the received signal strength indicator level is difficult to estimate accurately. Thus, by taking both baseband signals, using a higher order low overshoot low pass filter at the received signal strength indicator and a reduced limiter/received signal strength indicator range of about 30dB, the signal strength can be determined more accurately. Due to the reduced received signal strength indicator range the gain settling has to be done in at least three steps. After resetting the automatic gain control, performed in the state machine, it takes about 9 microseconds to determine the correct gain setting and an additional 5 microseconds to let the DC offset decay. Consequently, a relatively long settling time for a moderate dynamic range of the variable gain amplifier is required.

In *"A Fully Integrated Broadband Direct-Conversion Receiver for DBS Applications",* by Arun Jayaraman et al, 2000 IEEE International Solid-State Circuits Conference, a receiver chip is disclosed, the front end of which consists of a low noise variable gain attenuator followed by an I-Q mixer. The mixer output supplies the signal to a baseband section whose gain and bandwidth can be dynamically controlled. The baseband section includes variable gain amplifiers and tuneable filter elements, wherein the current steering variable gain amplifiers can produce a maximum baseband gain of 65dB with more than 55dB of gain control. The variable gain amplifiers have digital controls to set gain and offsets which allows for redistribution of baseband gain to accommodate different data rates. To prevent propagation of DC offsets due to leakage of the local oscillator and due to device miss matches, a continuous DC cancellation loop has to be provided around the first stage. In this receiver chip, however, the range of gain control is relatively moderate and the time period for the settling of the variable gain amplifiers is not specified.

It is thus important to improve the small-signal stability in the closed loop in automatic gain control in conjunction with a large dynamic range of the variable gain amplifiers used so that a transceiver may rapidly adapt to a wide dynamic range of RF signals.

### Disclosure of Invention

Generally, the present invention provides devices and methods for digitally controlling the gain of IF signals within a large dynamic range, wherein the settling time of the variable gain amplifiers is small, so that, in particular, the settling may be completed within the preamble of a data packet to match the receiver and the transmitter substantially without data loss. The present invention allows an effective gain control within a few clock cycles by employing a minimum number of digital components, such as an adder and a latch so that the automatic gain control may easily be integrated in a single chip transceiver for direct conversion without unduly adding to design complexity.

In one aspect of the invention an automatic gain control for transceiver devices comprises a variable gain amplifier section configured to output an amplified intermediate frequency signal and to vary a gain step-wise in a plurality of discrete gain settings in response to a control signal. The device firstly comprises a baseband rectifying section that is configured to provide, in synchronism with a clock signal, an output signal indicative of the amplified intermediate frequency signal. A comparator section is provided and is configured to compare the output signal with different plural reference voltages in synchronism with the clock signal. Moreover, a control section is provided and is configured to output the control signal in response to a comparator output signal provided by the comparator section.

In a further embodiment the comparator section includes a memory element for temporarily storing the comparator results and outputting the results in synchronism with said clock signal.

In a further embodiment adjacent gain settings differ from each other by approximately 3dB.
In a further embodiment said variable gain section is configured to output a baseband signal.

In a further embodiment said variable gain section includes a low noise amplifier having a variable gain for receiving a radio frequency signal and a filter unit having variable gain.

In a further embodiment said filter unit comprises at least one Bi-quad filter.

In a further embodiment the intermediate frequency rectifying section is configured to periodically pull an output thereof to a predefined reference voltage.

In a further embodiment the control section comprises an output for supplying a signal indicating a radio signal strength of a radio frequency signal supplied to the variable gain section.

According to a further aspect of the invention, an automatic gain controller for an RF receiver comprises a signal input section that is adapted to receive an intermediate frequency signal from a variable gain amplifier and to provide a sample signal indicative of the intermediate frequency signal. The controller further includes a control output to output a gain setting signal to the variable gain amplifier. A comparative section is configured to provide a comparison result of the sample signal with a plurality of threshold voltages. A gain setting controller is provided and is configured to generate the gain setting signal from the comparator result with a first number of discrete gain settings in synchronism with a clock signal that is provided to the gain setting controller. The gain setting controller, in turn, includes an adder and a latch enabled by the clock signal and connected between an output and an input of the adder to from an accumulator.
In a further embodiment a value range of said adder corresponds to the number of discrete gain settings.
In a further embodiment some of the plurality of threshold voltages cover a predefined dynamic range with a step size of approximately 3 dB.
In a further embodiment said predefined dynamic range is approximately 12 dB.
According to a further aspect of the invention, a method of automatically controlling the gain of an input signal comprises providing a clock signal and generating a sample signal from the input signal synchronised with the clock signal, wherein the sample signal is indicative of an amplitude of the input signal. The method further comprises comparing the sample signal with a plurality of distinct threshold voltages and generating a bit pattern according to the comparison synchronised with the clock signal. Moreover, numbers representing the bit pattern are successively added and synchronised with the clock signal and an output signal is generated that is indicative of a discrete gain setting.
In a further embodiment the method further comprises detecting said input signal and providing, upon detection of said input signal, a predefined number of clock cycles of a second clock signal as said clock signal.
In a further embodiment generating a sample signal includes measuring said input signal during one half period of said clock signal.
In a further embodiment said adder has a count range that corresponds to a predefined number of gain settings.
In a further embodiment comparing said sample signal is carried out at one of a rising edge and a falling edge of said clock signal.
In a further embodiment the method further comprises pulling said sample signal to a reference voltage after comparing said sample signal to the plurality of threshold voltages.
In a further embodiment a number at the output of said adder is temporarily stored in a latch coupled between the output and the second input of the adder.
In a further embodiment the latch is enabled in synchronism with said clock signal.

In a further aspect, an automatic gain controller for providing a gain setting signal for selecting one of a plurality of gain settings comprises a rectifying section configured to receive an input signal and to output a sample signal indicative of a signal amplitude of the input signal. A digitizing section is provided and configured to convert the sample signal into a digital number and an adder has an output, a first input to receive the digital number and a second input, wherein the adder has a count range corresponding to the plurality of gain settings. A latch has an input and an output, wherein the latch input is coupled to the adder output and the latch output is coupled to the second adder input. Additionally, the automatic gain controller comprises a decoder having an input coupled to the adder output and an output for providing the gain setting signal, wherein the digitizing section and the latch are operated in synchronism with a clock signal.
In a further embodiment said digitising section comprises a rectifying section and a comparator section coupled to plural different threshold voltages.
In a further embodiment said comparator section includes a latch for temporarily storing a bit pattern representing an output signal of the comparator section.
In a further embodiment the digitising section further comprises a coder configured to convert said bit pattern into said digital number.
In a further embodiment said rectifying section is configured to pull an output thereof to a defined reference voltage.
In a further embodiment said output of the rectifying section is pulled to the reference voltage in synchronism with said clock signal.
In a further embodiment the automatic gain controller is configured to accept a predefined number of clock periods of said clock signal.

### Brief Description of Drawings

Further advantages, objects and embodiments of the present invention are defined in the appended claims and will be become more apparent with the following detailed description when considered with reference to the accompanying drawings, in which:
figure 1a schematically shows a block diagram of one embodiment of an automatic gain control;
figure 1b schematically shows a block diagram of a variation of the embodiment shown in figure 1a;
figure 2 shows a flow diagram depicting one illustrative embodiment of a method of automatically controlling the gain of a transceiver device;
figure 3 schematically shows a timing diagram in which the time relationship between various components of the automatic gain controller is schematically depicted, when an input signal burst is received at the automatic gain controller; and
figure 4 schematically shows a time diagram depicting the effect of one illustrative embodiment, when a slowly increasing or decreasing signal is received.

### Modes for Carrying Out the Invention

It is to be noted that although the present invention is described with reference to the embodiments as illustrated in the following detailed description and in the accompanying drawings, the detailed description, as well as the drawings, are not intended to limit the present invention to the particular embodiment disclosed therein, but rather, the described embodiments merely exemplify the various aspects of the present invention, the scope of which is defined by the appended claims.

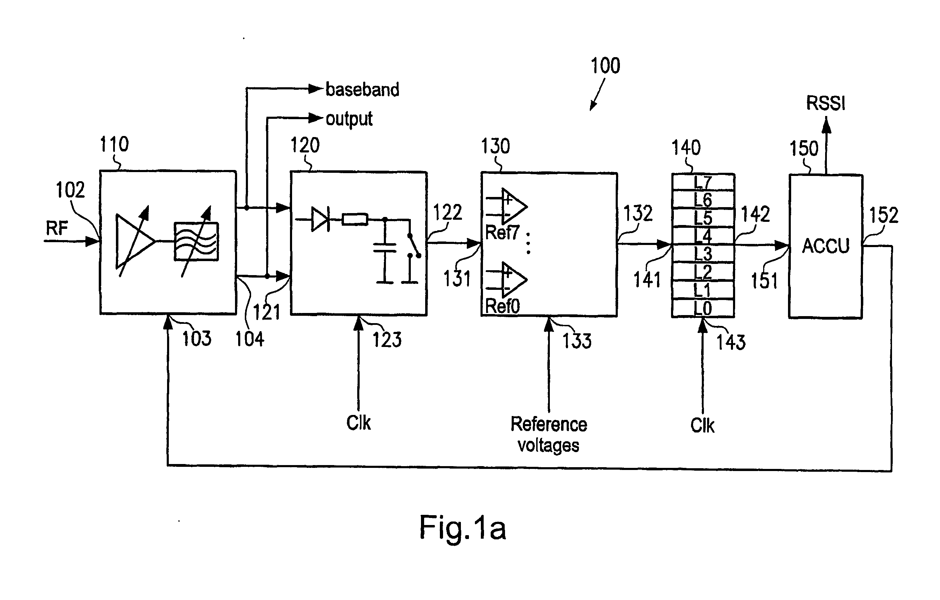

With reference to figure 1a, one illustrative embodiment will now be described. A transceiver device 100 comprises a variable gain amplifier and filter section 110, henceforth referred to variable gain section, having an input 102 for receiving an RF signal, an input 103 for receiving a gain setting signal and an output 104 for supplying an IF signal, such as a baseband signal when a direct conversion architecture is used, to the variable gain section 110. The variable gain section 110 is followed by a rectifying section 120 having an input 121 for receiving the IF signal of the variable gain section 110, an output 122 to provide a signal indicative of the amplitude of the input IF signal, and in one particular embodiment, a clock input 123 for receiving a clock signal enabling operation of the rectifying section 120.

A comparator section 130 is operatively coupled between the rectifying section 120 and a latch 140. The comparator section 130 comprises an input 131 for receiving the output of the rectifying section 120 and an output 132 for providing a bit pattern indicative of the signal amplitude entered at the input 131. Moreover, an input 133 is provided so as to receive a plurality of different reference voltages that are internally connected to individual comparator elements in the comparator section 130. The latch 140 is connected with its input 141 to the comparator section 130 and is connected with its output 142 to an input 151 of a control section 150. Furthermore, the latch 140 comprises a clock signal input 143 to receive a clock signal generated by a clock generator that is not shown in figure 1a. An output 152 of the control section 150 is connected to the input 103 of the variable gain section 110.

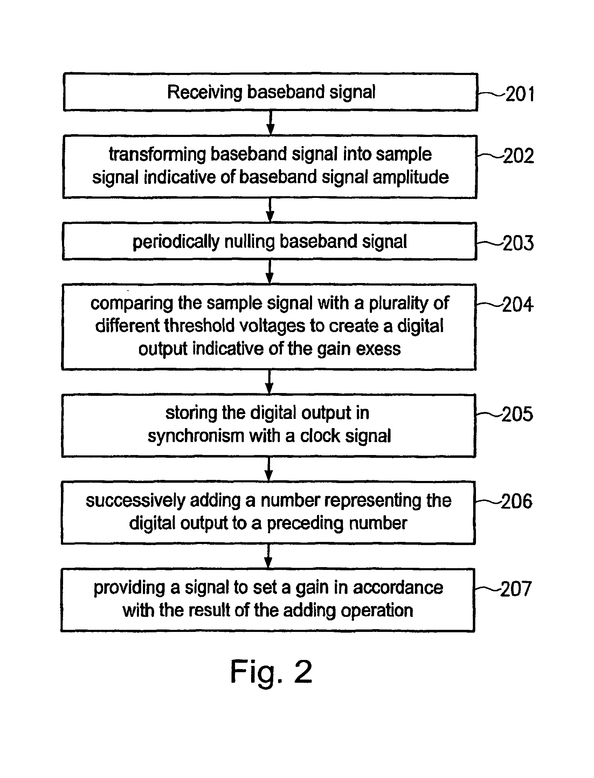

The operation of the transceiver device 100 will be described with reference to figures 1a and 2.

Firstly, an RF signal transmitted by, for example a WLAN, a TV satellite, or any other radio device, is received at input 102 and is processed by the variable gain section 110 so that an IF signal is obtained at the output 104. In case of a direct conversion topology in the variable gain section 110, the IF signal is provided as an in-phase and a quadrature baseband signal. At the output 104 the baseband signal is available for further processing and is concurrently supplied to the input 121 of the rectifying section 120 (step 201).

The signals received at the input 121 may be rectified and possibly smoothed to create a signal at the output 122 that is indicative of the amplitude of the baseband signals received at the input 121 (step 202).

In one embodiment, the clock signal may be received at the input 123, wherein the rectifying section 120 is periodically switched to a defined state to, for example discharge any capacitances that may be exist in the rectifying section 120. Otherwise, a large change of the signal at the input 121 may lead to a delayed response at the output 122 due to the RC time constant in the rectifying section 120. The signal supplied from the output 122 represents the amplitude of the baseband signals and is supplied to the comparator section 130, in which the signal is compared to a plurality of reference voltages supplied to the input 133.
In one particular embodiment, the reference voltages may differ from each other according to a logarithmic scale so that a bit pattern provided at the output 132 may indicate the gain excess on a logarithmic scale with respect to a predefined desired voltage. The comparator section 130 may be configured so as to provide a logic 1 and the bit pattern as soon as the signal crosses the corresponding reference voltage. It should be appreciated, however, that any other logic may be used in the comparator section 130 to create an appropriate bit pattern .Upon reception of the rising edge or the falling edge of the clock signal the bit pattern at the input 141 of the latch 140 is temporarily stored and is available at the output 142 (step 205).

The bit pattern stored in the latch 140 is supplied to the control section 150 in which the bit pattern may be transformed into a digital number representing the currently valid gain excess. This digital number is converted into a respective gain setting to which the variable gain section 110 is to be set so as to achieve or approach the required gain setting. The conversion of the digital number into the corresponding gain setting may be performed by successively adding the gain excess number to a number obtained at the preceding clock cycle (step 206).

Subsequently, a signal indicative of the gain setting is supplied to the variable gain section 110. In one embodiment, at least some of the reference voltages supplied to the comparator section 130 differ from each other by a minimal gain step of the variable gain section 110 to provide for a "fine" resolution. The gain setting of the variable gain section 110 may then be effected rapidly within one clock period, when the gain excess represented by the signal at the output 122 of the rectifying section 120 is within the range of these finely tuned reference voltages supplied to the input 133 of the comparator section 130. If the signal amplitude provided at the output 122, however, exceeds the highest one of the reference voltages, the gain setting of the variable gain section 110 may be reduced by a predefined amount. In one embodiment at least one reference voltage is selected so as to indicate a large gain excess, for example a gain excess of 36 dB, and the gain setting is reduced by this gain excess to accelerate gain reduction for large signal variations.

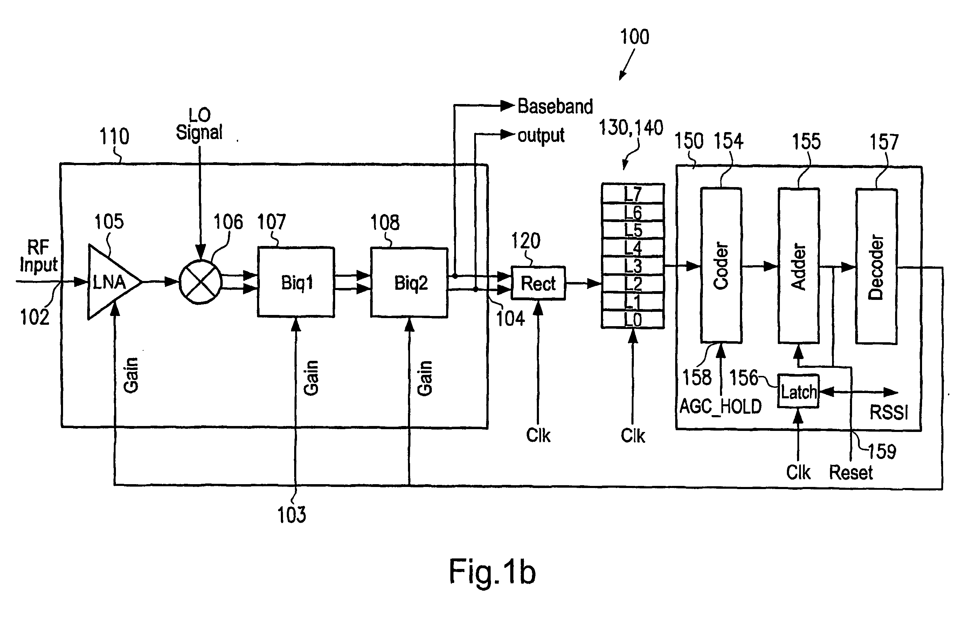

Figure 1b shows a more detailed variation of the embodiment of figure 1a. In figure 1b the same reference numbers are used for equivalent components and parts.

The transceiver device 100 comprises the variable gain section 110 including, at the input stage, a low noise amplifier (LNA) 105 followed by a mixer 106 that is configured to provide the in-phase signal and the quadrature signal upon reception of the IF signal of a local oscillator (not shown). Two base band filters 107 and 108, in the present example provided as Bi-quad filters form the final stage of the variable gain section 110. In the embodiment show n in figure 1b, the LNA 105, the first filter 107 and the second filter 108 are all adapted to receive a gain setting signal that may correspondingly adjust the gain of the corresponding stage so that the total gain of the variable gain section 110 is defined by the product of the individual gain settings. In this way, the arrangement allows the gain adjustment by switching binary weighted resistors so that the corresponding gain settings of the individual components 105, 107 and 108 leads to an addition in the logarithmic dB domain. In one particular embodiment, the gain of the variable gain section 110 may be adjusted according to 28 gain steps that are 3dB separated so that in total 29 discrete gain settings are available. Accordingly, the available dynamic range is 84dB.

In figure 1b, the control section 150 comprises a coder 154 that is connected to the comparator-latch section indicated as 130, 140, followed by an adder 155 including a latch 156 connected between the output and the input of the adder. The output of the adder 155 is also coupled to a decoder 157, the output of which is connected to the input 103 of the variable gain section 110. The adder 155 may comprise a reset input 159 to establish a defined state of the adder 155 upon receiving a reset signal. Moreover, the adder 155 is preferably adapted to show saturation characteristics, i.e. the adder 155 is, in one embodiment, configured so as to not count below zero and above 28. If a different number of gain settings is used, the adder 155 may appropriately be adapted to the corresponding number of gain settings in the variable gain section 110.

In operation, the variable gain section 110 receives an RF input signal at the input 102 which is amplified by the LNA 105 according to the presently valid gain setting. For convenience, it is assumed that the variable gain section 110 is currently searching for an RF signal and the total gain is adjusted to the maximum gain, which may, as in the embodiment described above, be 84dB. The RF signal amplified by the LNA 105 as a first amplifier stage is supplied to the mixer 106 that is driven by the two phase shifted frequency signals of the local oscillator. The local oscillator is matched to the carrier frequency of the FR signal and the resulting baseband signals are filtered and amplified by the Bi-quad filters 107 and 108. The finally obtained baseband signal is available at the output 104 and is also supplied to the rectifying section 120 which, in synchronism with the clock signal, rectifies the baseband signal to produce a rectified signal or sample signal that is indicative of the signal amplitude of the baseband output. For example, during the high period of the clock signal, the output of the rectifying section 120 may be pulled to zero, as depicted in figure 1a, whereas during the low period of the clock signal, measurement of the rectified baseband signal takes place by means of the comparator-latch section 130, 140. Periodically pulling the outputs of the rectifying section 120 to zero substantially prevents the rectifying section 120 from rectifying DC step responses, and also substantially avoids a too slow decrease of the rectifying output signal due to the averaging RC time constant after large gain reductions have occurred. At the rising edge, or alternatively at the falling edge of the clock signal, the rectified output signal supplied to the comparator latches is temporarily stored in the latches and is available at the output of the comparator latch section 130, 140.

In an embodiment having a dynamic range of 84dB, as described above, comparators and latches L0 to L7 may compare the rectified baseband signal with 8 different reference voltages to create a bit pattern indicative of the amplitude of the baseband signal and thus indicative of the presently valid gain excess of the variable gain section 110. For example, the reference voltage supplied to the comparator/latch L2 may represent the desired output voltage of the variable gain section 110 and may be indicated as the 0dB bit. If, for instance, the desired output voltage is approximately 125 mV, the reference voltage of L2 may be selected to approximately 2.5dB above 125 mV which corresponds to about 167 mV. The comparators/latches L3 to L5 may receive reference voltages that are each separated by 3dB from the adjacent reference voltage. The comparator/latch L7 may receive a reference voltage indicating a signal amplitude exceeding 36dB above the 0dB signal level, while comparator/latch L6 may receive a reference voltage indicating a signal amplitude exceeding 24dB. Preferably, the 36dB level is selected to be below or at the saturation level of the variable gain section 110. When the RF input signal has a relatively large strength the rectifying section 120 may provide an output signal to the comparator/latch section 130, 140 that exceeds the reference voltage of L7 so that the coder 154 generates a digital number indicating a gain step that is appropriate for reducing the total gain by 36dB. The digital number output from the coder 154 is supplied to the adder 155 and is added to the digital number provided by the latch 156 at the rising edge of the clock signal. Since it is assumed that the present gain setting is the maximum gain, i.e. 84dB, the adder output temporarily stored in the latch 156 and provided to the adder input at the rising edge of the clock signal is zero so that, after the rising edge of the clock signal, the adder provides a number to the decoder 157 that indicates the new gain setting reduced by 36dB. The decoder 157 provides a gain setting signal to the variable gain section 110 that is appropriate to adjust the total gain to be 36dB below the previous setting, i.e. 84dB minus 36dB.

In the next measurement cycle of the rectifying section 120 the signal obtained by the newly set variable gain section 110 is again compared with the reference voltages of L2 to L7 and, in case the signal is now within the 12dB range of L2 to L5, the total gain of the variable gain section 110 is set in this step so as to produce a baseband output that is approximately at the desired reference voltage of L2 corresponding to the 0dB signal.

If the signal obtained by the newly set variable gain section 110 again exceeds the threshold of L7, the gain is again reduced by 36dB and thus, according to the dynamic range of 84dB, is after the next gain reduction step within the 12dB range of L2 - L5.

If the signal obtained by the newly set variable gain section 110 exceeds the threshold of L6, is, however, below the threshold of L7, the gain is again reduced by 24dB and thus is after the next gain reduction step within the 12dB range of L2 - L5.

According to this embodiment, the gain reduction is designed in such a way that the residual receiver gain excess is zero or more, thereby allowing a monotonic settling behaviour of the gain adjustment of the variable gain section 110. Thus, any over- or under-shooting of the total gain is substantially avoided.. Moreover, the gain settling is achieved in three steps at most. When the gain control is designed to mainly respond to RF bursts, instead of L6 and L7 the comparator latches L0 and L1 may be used for this purpose. Otherwise, the latches L0 and L1 may be used for increasing gain, as will be described in more detail below.

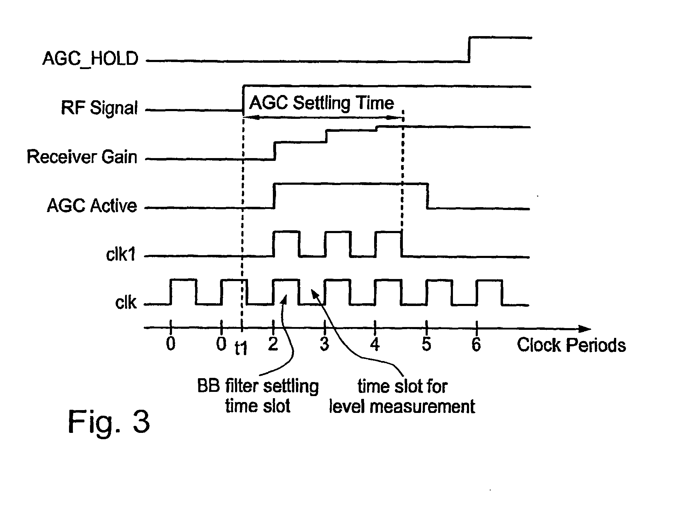

With reference to figure 3, the operation of an illustrative embodiment of the automatic gain control is described by a corresponding time diagram for the case that the transceiver device 100 observes a specified radio channel for a potential RF signal, as is the case in a WLAN when a peripheral device is waiting for a data transmission. The embodiment for describing this event is configured as shown in figure 1b, wherein the clock frequency that is selected at 22MHz/26 is equal to 846.153KHz corresponding to a clock period of 1.1818 microseconds. 22MHz represent the clock rate of the IEEE802.11B standard with 11 Megabits per second. The automatic gain control is designed to adjust the gain setting in three steps at most, so that the gain settling is completed well within the first 128 bits of the preamble of an according RF burst in compliance with the above-identified standard.

In figure 3, the horizontal axis is divided into discrete clock periods of the clock signal CLK. As previously explained, during the high period of the clock signal, the output of the rectifying section 120 may be pulled to zero and no measurement is performed. At a time point t1, an RF signal may be received at the input 102 and is amplified with a gain factor of 84dB, since usually the transceiver device 100 is put to the maximum gain when observing a radio channel for a potential signal. At the following low level of the clock signal a sample signal is generated representing the amplitude of the baseband signal output by the variable gain section 110. During the rising edge of the clock signal, i.e. at the beginning of clock period 2, the signal at the output of the rectifying section 120 is compared with the reference voltages, and for a relatively large RF signal, the comparator/latch L7 indicates that the gain excess exceeds 36dB so that the decoder 157 provides a gain setting signal causing the variable gain setting 110 to reduce gain by 36dB. In the following high level of the clock signal, the output of the rectifying section 120 are pulled to zero and the variable gain section 110 may settle to the new gain setting of 48dB. During the next low level of the clock signal the baseband signal amplified according to the newly adjusted gain setting is rectified and supplied to the comparator/latch section 130, 140. During the next rising edge of the clock signal, i.e. at the beginning of clock period 3, the comparator result is stored and is also provided to the control section 150 in which the gain setting signal for the new gain setting is generated.
It is assumed that the signal supplied to the comparator section is still above the 12 dB range covered by L2 - L5, and is also above the reference voltage of L6, but is below the reference voltage of L7, i.e. the gain excess exceeds 24dB but is below 36dB. Thus according to the newly obtained gain setting signal, the gain is reduced by 24dB. In the following high level of the clock signal, the output of rectifying section 120 is pulled to zero and the variable gain section 110 settles at a gain of 24dB.

It is thus ensured that the signal level obtained after the third measurement cycle is well within the zero and 12dB range so that the final gain adjustment is obtained in the third clock period after the occurrence of the RF burst. Moreover, the latches L0, L1 may be set to about -3 dB and -12 dB, respectively, to provide for gain increase when the signal varies only slowly after gain adaptation to the RF burst. The embodiments described above therefore represent a compromise between the number of reference voltages to be provided and the number of clock periods required for settlement of the gain setting. In the above described embodiment it is ensured that, with a provision of 8 reference voltages, the gain settling is obtained within 3 clock periods over the entire dynamic range of 84dB well within the preamble of the above-identified IEEE 802.11b standard. Thereby it is assumed that the 0dB reference voltage is selected so that any potential RF signal does not exceed the 0dB reference voltage at a gain setting corresponding to 0dB which would mean that the desired baseband signal amplitude would be obtained without amplification.

In a further embodiment, the clock signal supplied to the rectifying section 120 and the latch 156 may be delayed with respect to the clock signal supplied to the latch 140 so as to ensure that the latch stores the comparison results before the outputs of the rectifying section 120 are pulled to zero.

In one embodiment, in the mode of observing a radio channel for potential RF bursts, the clock signal supplied to the latch 140 may be gated, so that only 3 subsequent clock periods are supplied to the latch 140, thereby significantly reducing the risk of filter switching due to any erroneous measurement activities. A corresponding filter switching could otherwise inappropriately distort the received signal. In figure 3 the gated clock signal is indicated as clk1. Moreover, according to a further illustrative embodiment, the automatic gain control may be set on hold by a respective enable signal supplied for example to the coder 154. As previously described, a reset signal supplied at input 159 may reset the adder to a defined state, such as a zero state. Furthermore, the output of the adder may be used as a received signal strength indicator.

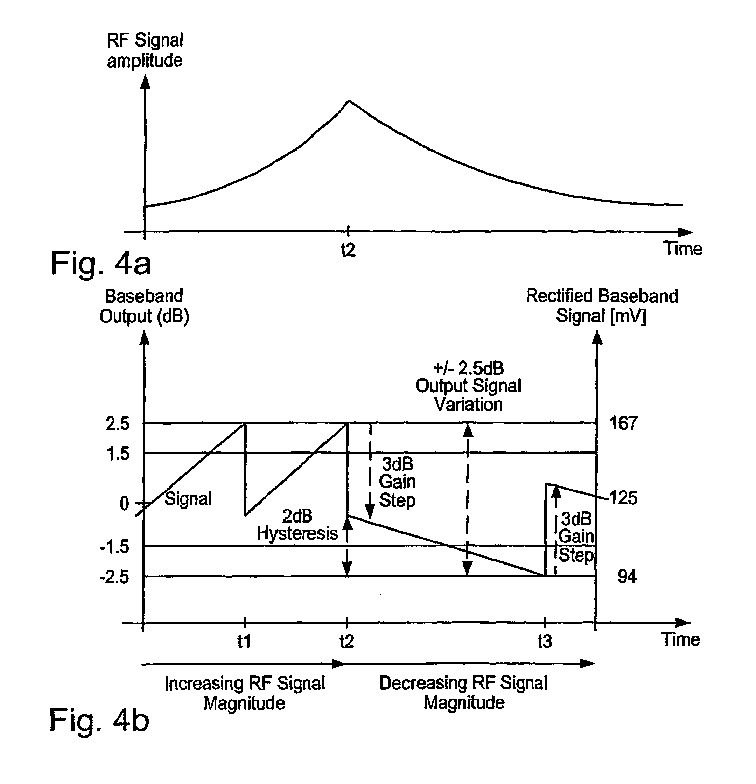

With reference to figure 4a and 4b, the operation of the embodiments illustrated in figure 1b will now be described, wherein the automatic gain control is accomplished for a relatively slowly increasing or decreasing input signal.

Figure 4a shows a diagram, wherein the horizontal axis indicates the time and the vertical axis represents the signal amplitude of an incoming RF signal. It is assumed that the received RF signal monotonically increase up to a time point t2, at which the RF signal then continuously decreases, for example, due to a change of the position of the transceiver, or the like.

In figure 4b, the corresponding rectified signal amplitude measured during the low levels of the clock signal and obtained at the output of the rectifying section 120 is illustrated with respect to the dB domain (left hand axis) and the corresponding linear scale calibrated in mV (right hand axis). It is assumed that, at time below t0 corresponding to the origin of the time axis, the rectified signal amplitude is approximately at the desired signal amplitude of 0dB or of 125 mV. At t0 the RF signal and thus the rectified signal amplitude rises and reaches at time point t1 the reference voltage of the comparator L2 of 2.5dB or 167 mV. Accordingly, the automatic gain control reduces the gain within one clock period by 3dB so that the rectified signal amplitude after t1 is approximately -0.5dB. From t1 to t2, the RF signal amplitude still increases and thus the rectified signal amplitude increases, starting from -0.5dB, and reaches at time point t2 again the 2.5dB reference voltage of the comparator L2. Consequently, the gain is reduced again by 3dB within one clock period so that the rectified signal amplitude is again at -0.5dB.

At time point t2 the RF signal amplitude decreases, for example due to any environmental influences or the like and For this cases increasing the gain of the variable gain section 110 is required. In the embodiment of figure 1b the comparator reference voltage of L1 may be adjusted to -2.5dB, whereas the reference voltage of L0 may be adjusted to -12dB. It should be noted, however, that any other number of reference voltages may be provided if desired.

At time point t3, the rectified signal amplitude reaches the -2.5db reference voltage of the comparator L1 and consequently, the automatic gain control increases the gain by 3dB within one clock period. Consequently, the rectified signal amplitude will rise to 0.5dB according to the new gain setting. Consequently, in the above embodiment, the variation of the rectified signal amplitude and thus the variation of the baseband signal is within the range of +/-2.5dB. It should be noted, however, that any other appropriate small signal variation may be obtained by correspondingly selecting the reference voltages and the gain steps. Moreover, in the example described above, a 2dB hysteresis is obtained as indicated in figure 4b. Generally, output signal variation is determined by the gain step size and the hysteresis by the following equation: output variation = +/- 1/2 x (gain step size + hysteresis).

For a rapidly decreasing RF input signal that is, for example, indicated by a rectified signal amplitude below the reference voltage of L0, the automatic gain control increases gain by 12dB. Since for a desired output voltage of about 125 mV, typically a DC offset of about +/-10mV has to be tolerated, it may be difficult to detect lower levels of the rectified signal amplitude as 10mV already represent a signal level that is about 28dB below the nominal output voltage.

In conclusion, an automatic gain control is provided that allows rapid gain settling even within the preamble of data packets coded according to the IEEE 802.11B standard, in that a digital closed loop is established, which is broken only by the latches provided to temporarily store a bit pattern representative of the baseband signal. After updating the latch contents, the digital signals may travel synchronously through a coder, an adder and a decoder to effect a new gain setting. The adder includes a latch as a feedback element so as to form an accumulator with saturation behaviour. For maximum gain, the accumulator state is zero. In the steady state of the automatic gain control, the coder output is zero and the adder output remains constant.

According to one embodiment, a fully controllable dynamic range of 84dB is obtained with 29 gain settings separated by 3dB, wherein a maximum settling time of the automatic gain control may be set to a predefined number of clock periods.

Although specific embodiments are described referring to a dynamic range of 84 dB any other desired range may be selected. By reducing the dynamic range the gain settling may be accelerated or the step size may be reduced. Moreover, the clock frequency may be selected in accordance with design requirements as long as is ensured that the gain settling and measurement of the baseband signal are completed within one half of a clock period.

### Industrial Applicability

Evidently, the present invention may advantageously be applied under industrial conditions.

## Claims

1. An automatic gain control for a transceiver device, comprising:
a variable gain section (110) configured to output an amplified intermediate frequency signal and to vary a gain step wise in a plurality of discrete gain settings in response to a control signal (103);
an intermediate frequency rectifying section (120) configured to provide, in synchronism with a clock signal, a sample signal indicative of the amplified intermediate frequency signal;
a comparator section (130, 140) configured to compare said sample signal with plural different reference voltages in synchronism with said clock signal; and
a control section (150) configured to output said control signal in response to a comparator output signal provided by said comparator section (130, 140).

2. The automatic gain control of claim 1, wherein said control section (150) comprises an accumulator including an adder (155) having an input and an output, and a memory device (156) connected between said input and said output for temporarily storing the output of said adder in synchronism with said clock signal.

3. The automatic gain control of claim 2, wherein said accumulator is adapted to have saturation characteristics with respect to said plurality of discrete gain settings.

4. The automatic gain control of claim 3, wherein the control section further comprises a coder (154) for converting said comparator output signal into a digital number.

5. The automatic gain control of claim 4, wherein the control section further comprises a decoder (157) configured to convert the output of said adder (155) into said control signal.

6. The automatic gain control of claim 1, configured to achieve gain settling within a predefined number of clock periods.

7. An automatic gain controller for a radio frequency receiver, comprising:
a signal input section (110, 120) adapted to receive an intermediate frequency signal and to provide a sample signal indicative of an amplitude of the intermediate frequency signal;
a control output (103) to output a gain setting signal;
a comparator section (130, 140) configured to provide a comparison result of said sample signal and a plurality of distinct threshold voltages; and
a gain setting controller (150) configured to provide said gain setting signal from said comaprator result with a first number of discrete gain settings in synchronism with a clock signal provided to the gain setting controller, wherein the gain setting controller (150) includes an adder (155) and a latch (156) enabled by said clock signal and connected between an output and an input of said adder (155) so as to form an accumulator.

8. The automatic gain controller of claim 7, wherein said signal input section comprises a rectifying section (120) actuable in synchronism with said clock signal.

9. The automatic gain controller of claim 7, wherein said comparator section further comprises a latch to temporarily store a bit pattern representing said comparison result.

10. A method of automatically controlling gain of an input signal, the method comprising:
providing a clock signal;
generating (202) a sample signal from said input signal in synchronism with said clock signal, the sample signal being indicative of an amplitude of the input signal;
comparing (204) said sample signal with a plurality of distinct thresholds voltages;
generating (204) a bit pattern from said comparison in synchronism with the clock signal;
providing a number representing said bit pattern to a first input of an adder;
providing (206) a number representing the bit pattern of a previously obtained sample signal to a second input of said adder in synchronism with said clock signal; and
generating (207) a gain setting signal from an output of said adder, wherein said gain setting signal is adapted to control the gain of a variable gain amplifier section.

## Patentansprüche

1. Automatische Verstärkungssteuerung für ein Sende/Empfangs-Element, mit:
einem variablen Verstärkungsabschnitt (110), der ausgebildet ist, ein verstärktes Zwischenfrequenzsignal auszugeben und eine Verstärkung schrittweise in mehreren diskreten Verstärkungseinstellungen in Reaktion auf ein Steuersignal (103) zu ändern;
einem Zwischenfrequenzgleichrichterabschnitt (120), der ausgebildet ist, synchron zu einem Taktsignal ein Abtastsignal bereitzustellen, das das verstärkte Zwischenfrequenzsignal kennzeichnet;
einem Komparatorabschnitt (130, 140), der ausgebildet ist, das Abtastsignal mit mehreren unterschiedlichen Referenzspannungen synchron zu dem Taktsignal zu vergleichen; und
einem Steuerabschnitt (150), der ausgebildet ist, das Steuersignal in Reaktion auf ein von dem Komparatorabschnitt (130, 140) geliefertes Komparatorausgangssignal auszugeben.

2. Die automatische Verstärkungssteuerung nach Anspruch 1, wobei der Steuerabschnitt (150) einen Akkumulator mit einem Addierer (155) mit einem Eingang und einem Ausgang, und ein Speicherelement (156) aufweist, das zwischen dem Eingang und dem Ausgang angeschlossen ist, um zwischenzeitlich das Ausgangssignal des Addierers synchron zu dem Taktsignal zu speichern.

3. Die automatische Verstärkungssteuerung nach Anspruch 2, wobei der Akkumulator so ausgebildet ist, dass dieser Sättigungseigenschaften im Hinblick auf die mehreren diskreten Verstärkungseinstellungen aufweist.

4. Die automatische Verstärkungssteuerung nach Anspruch 3, wobei der Steuerabschnitt ferner einen Codierer (154) aufweist, um das Komparatorausgangssignal in eine digitale Zahl umzuwandeln.

5. Die automatische Verstärkungssteuerung nach Anspruch 4, wobei der Steuerabschnitt ferner einen Decodierer (157) aufweist, der ausgebildet ist, das Ausgangssignal des Addierers (155) in das Steuersignal umzuwandeln.

6. Die automatische Verstärkungssteuerung nach Anspruch 1, die ausgebildet ist, die Verstärkungseinregelung innerhalb einer vordefinierten Anzahl von Taktperioden zu erreichen.

7. Automatische Verstärkungssteuerung für einen Radiofrequenzempfänger, mit:
einem Signaleingangsabschnitt (110, 120), der ausgebildet ist, ein Zwischenfrequenzsignal zu empfangen und ein Abtastsignal bereitzustellen, das eine Amplitude des Zwischenfrequenzsignals kennzeichnet;
einem Steuerausgang (103), um ein Verstärkungseinstellungssignal auszugeben;
einem Komparatorabschnitt (130, 140), der ausgebildet ist, ein Vergleichsergebnis des Abtastsignals mit mehreren unterschiedlichen Schwellwertspannungen bereitzustellen; und
einer Verstärkungseinstellungssteuerung (150), die ausgebildet ist, das Verstärkungseinstellungssignal aus dem Komparatorsignal mit einer ersten Anzahl diskreter Verstärkungseinstellungen synchron zu einem Taktsignal, das der Verstärkungseinstellungssteuerung zugeleitet ist, bereitzustellen, wobei die Verstärkungseinstellungssteuerung (150) einen Addierer (155) und ein Latch (156) aufweist, das von dem Taktsignal freigegeben wird, und das zwischen einem Ausgang und einem Eingang des Addierers (155) angeschlossen ist, um einen Akkumulator zu bilden.

8. Die automatische Verstärkungssteuerung nach Anspruch 7, wobei der Signaleingangsabschnitt einen Gleichrichterabschnitt (120), der synchron zu dem Taktsignal betätigbar ist, aufweist.

9. Die automatische Verstärkungssteuerung nach Anspruch 7, wobei der Komparatorabschnitt ferner ein Latch umfasst, um zwischenzeitlich ein das Vergleichsergebnis repräsentierendes Bitmuster zu speichern.

10. Verfahren zum automatischen Steuern einer Verstärkung eines Eingangssignals, wobei das Verfahren umfasst:
Bereitstellen eines Taktsignals;
Erzeugen (202) eines Abtastsignals aus dem Eingangssignal synchron zu dem Taktsignal, wobei das Abtastsignal eine Amplitude des Eingangssignals kennzeichnet;
Vergleichen (204) des Abtastsignals mit mehreren unterschiedlichen Schwellwertspannungen;
Erzeugen (204) eines Bitmusters aus dem Vergleich synchron zu dem Taktsignal;
Zuführen einer Zahl, die das Bitmuster repräsentiert, zu einem Eingang eines Addierers;
Zuführen (206) einer Zahl, die das Bitmuster eines zuvor erhaltenen Abtastsignals repräsentiert, zu einem zweiten Eingang des Addierers synchron zu dem Taktsignal; und
Erzeugen (207) eines Verstärkungseinstellungssignals auf einem Ausgangssignal des Addierers, wobei das Verstärkungseinstellungssignal so gebildet ist, um die Verstärkung eines Verstärkerabschnitts mit variabler Verstärkung zu steuern.

## Revendications

1. Commande automatique de gain pour un dispositif émetteur-récepteur, comprenant :
une section à gain variable (110) configurée pour fournir en sortie un signal amplifié à fréquence intermédiaire et pour faire varier un gain pas à pas selon une pluralité de réglages de gain discrets en réponse à un signal de commande (103),
une section de redressement à fréquence intermédiaire (120) configurée pour fournir, en synchronisme avec un signal d'horloge, un signal échantillon indicatif du signal amplifié à fréquence intermédiaire,
une section de comparateur (130, 140) configurée pour comparer ledit signal échantillon à plusieurs tensions de référence différentes en synchronisme avec ledit signal d'horloge, et
une section de commande (150) configurée pour fournir en sortie ledit signal de commande en réponse à un signal de sortie de comparateur fourni par ladite section de comparateur (130, 140).

2. Commande automatique de gain selon la revendication 1, dans laquelle ladite section de commande (150) comprend un accumulateur incluant un additionneur (155) ayant une entrée et une sortie, ainsi qu'un dispositif de mémoire (156) branché entre ladite entrée et ladite sortie afin de mémoriser temporairement la sortie dudit additionneur en synchronisme avec ledit signal d'horloge.

3. Commande automatique de gain selon la revendication 2, dans laquelle ledit accumulateur est conçu pour présenter des caractéristiques de saturation par rapport à ladite pluralité de réglages de gain discrets.

4. Commande automatique de gain selon la revendication 3, dans laquelle la section de commande comprend en outre un codeur (154) destiné à convertir ledit signal de sortie de comparateur en un nombre numérique.

5. Commande automatique de gain selon la revendication 4, dans laquelle la section de commande comprend en outre un décodeur (157) configuré pour convertir la sortie dudit additionneur (155) en ledit signal de commande.

6. Commande automatique de gain selon la revendication 1, configurée pour obtenir une stabilisation du gain à l'intérieur d'un nombre prédéfini de périodes d'horloge.

7. Contrôleur automatique de gain pour un émetteur-récepteur à haute fréquence, comprenant :
une section d'entrée de signal (110, 120) conçue pour recevoir un signal à fréquence intermédiaire et pour fournir un signal échantillon indicatif d'une amplitude du signal à fréquence intermédiaire,
une sortie de commande (103) pour fournir en sortie un signal de réglage de gain,
une section de comparateur (130, 140) configurée pour fournir un résultat de comparaison dudit signal échantillon à une pluralité de tensions de seuil distinctes, et
un contrôleur de réglage de gain (150) configuré pour fournir ledit signal de réglage de gain à partir dudit résultat du comparateur avec un premier nombre de réglages de gain discrets en synchronisme avec un signal d'horloge fourni au contrôleur de réglage de gain, dans lequel le contrôleur de réglage de gain (150) comprend un additionneur (155) et une mémoire tampon (156) validée par ledit signal d'horloge et branchée entre une sortie et une entrée dudit additionneur (155) de façon à former un accumulateur.

8. Contrôleur automatique de gain selon la revendication 7, dans lequel ladite section d'entrée de signal comprend une section de redressement (120) pouvant être actionnée en synchronisme avec ledit signal d'horloge.

9. Contrôleur automatique de gain selon la revendication 7, dans lequel ladite section de comparateur comprend en outre un circuit de verrouillage pour mémoriser temporairement une séquence de bits représentant ledit résultat de comparaison.

10. Procédé de commande automatique du gain d'un signal d'entrée, le procédé comprenant :
la fourniture d'un signal d'horloge,
la génération (202) d'un signal échantillon à partir dudit signal d'entrée en synchronisme avec ledit signal d'horloge, le signal échantillon étant indicatif d'une amplitude du signal d'entrée,
la comparaison (204) dudit signal échantillon à une pluralité de tensions de seuil distinctes,
la génération (204) d'une séquence de bits à partir de ladite comparaison en synchronisme avec le signal d'horloge,
la fourniture d'un nombre représentant ladite séquence de bits à une première entrée d'un additionneur,
la fourniture (206) d'un nombre représentant la séquence de bits d'un signal échantillon obtenu précédemment à une seconde entrée dudit additionneur en synchronisme avec ledit signal d'horloge, et
la génération (207) d'un signal de réglage de gain à partir d'une sortie dudit additionneur, où ledit signal de réglage de gain est conçu pour commander le gain d'une section d'amplificateur à gain variable.
